Europäisches Patentamt

European Patent Office

Office européen des brevets

(19)

(11) Numéro de publication : **0 448 463 A1**

(12) # DEMANDE DE BREVET EUROPEEN

(21) Numéro de dépôt : **91400746.3**

(22) Date de dépôt : **20.03.91**

(51) Int. Cl.⁵ : **C04B 35/00, H01L 39/24**

(30) Priorité : **23.03.90 FR 9003710**

(43) Date de publication de la demande :
**25.09.91 Bulletin 91/39**

(84) Etats contractants désignés :
**AT BE CH DE DK ES FR GB GR IT LI LU NL SE**

(71) Demandeur : **RHONE-POULENC CHIMIE**
**25, quai Paul Doumer**
**F-92408 Courbevoie Cédex (FR)**

(72) Inventeur : **Vilmin, Gabriel**
**B-8 Les Petits Bussys, 6, rue d'Andilly**
**F-95600 Eaubonne (FR)**

(74) Mandataire : **Dubruc, Philippe et al**
**RHONE-POULENC CHIMIE Service**
**IOM/BREVETS, 25,quai Paul Doumer**
**F-92408 Courbevoie (FR)**

(54) **Procédé de préparation de phases supraconductrices à base de bismuth, strontium, calcium et cuivre et d'un élément stabilisant.**

(57)     L'invention concerne un procédé de préparation d'un produit supraconducteur à base de bismuth, strontium, calcium, cuivre et oxygène, comprenant au moins un élément stabilisant choisi dans le groupe comprenant le plomb, l'antimoine et l'étain et qui est caractérisé en ce qu'il comprend les étapes suivantes :

a - préparation d'une solution comprenant les éléments bismuth, strontium, calcium, cuivre et au moins un élément stabilisant,

b - séchage de ladite solution,

c - calcination sous air du produit séché.

On obtient ainsi un produit à une seule phase présentant une température de transition unique.

EP 0 448 463 A1

# PROCEDE DE PREPARATION DE PHASES SUPRACONDUCTRICES A BASE DE BISMUTH, STRONTIUM, CALCIUM ET CUIVRE ET D'UN ELEMENT STABILISANT

La présente invention concerne un procédé de préparation d'une phase supraconductrice à base de bismuth, strontium, calcium cuivre et oxygène comprenant en outre au moins un élément stabilisant.

Le domaine de la supraconductivité connaît depuis peu un essor remarquable et les recherches mettent à jour de nouvelles phases présentant une température "critique" supérieure à 80K voire supérieure à 100K.

Parmi ces nouveaux matériaux figurent les phases sans terre rare mais à base de bismuth, définies par la formule générale suivante :

$$Bi_2 Sr_2 Ca_{n-1} Cu_n O_x$$

où n varie de 1 à 3.

La phase constituant le plus grand intérêt est celle pour laquelle n vaut 3, puisqu'elle présente une température "critique" de 115K. Cependant, il est difficile d'obtenir cette phase pure. En effet, les procédés connus ne permettent généralement d'obtenir qu'un mélange de produits dans lequel la phase 2223 n'est pas majoritaire.

Un moyen pour stabiliser et obtenir ainsi la phase 2223 pure est d'effectuer une substitution partielle du plomb au bismuth. Cependant, les procédés existants concernant la préparation d'une phase 2223 au bismuth stabilisée au plomb, notamment les procédés par chamottage d'oxydes, nécessitent des conditions opératoires peu envisageables au niveau industriel du fait de leur complexité et de leur coût.

La présente invention a donc pour objet de proposer un procédé simple et industrialisable pour l'obtention d'une phase pure au bismuth du type précité.

Ainsi, l'invention concerne un procédé de préparation d'un produit supraconducteur à base de bismuth, strontium, calcium, cuivre et oxygène comprenant au moins un élément stabilisant choisi dans le groupe comprenant le plomb, l'antimoine et l'étain.

Ce procédé est caractérisé en ce qu'il comprend les étapes suivantes :

a - Préparation d'une solution comprenant les éléments bismuth, strontium, calcium, cuivre et au moins un élément stabilisant

b - Séchage de ladite solution

c - Calcination sous air du produit séché.

Le procédé selon l'invention permet d'obtenir plus particulièrement des produits supraconducteurs à base de bismuth répondant à la formule (I) suivante :

$$Bi_x M_y Sr_z Ca_t Cu_v O_w \quad (I)$$

où

$$1,5 \leqq x + y \leqq 2,5$$
$$2 \leqq v \leqq 4$$

$$3 \leqq z + t \leqq 5$$

x, y, z et t étant tous supérieurs à 0 et w étant déduit de la valeur des paramètres x, y, z, t et v et des valences des cations respectifs dans le produit;

et où M représente un ou plusieurs éléments parmi le plomb, l'antimoine ou l'étain.

L'un des avantages de la présente invention réside dans le fait que les conditions opératoires de la calcination sont transposables au niveau industriel. En effet, au contraire de certains procédés necessitant l'utilisation de gaz spécifiques, la calcination selon le procédé de l'invention est effectuée sous air.

D'autre part, et c'est un avantage supplémentaire, la durée de la calcination est considérablement diminuée par rapport aux procédés connus.

D'autres aspects et avantages de l'invention apparaîtront à la lecture de la description et des dessins annexés dans lesquels :

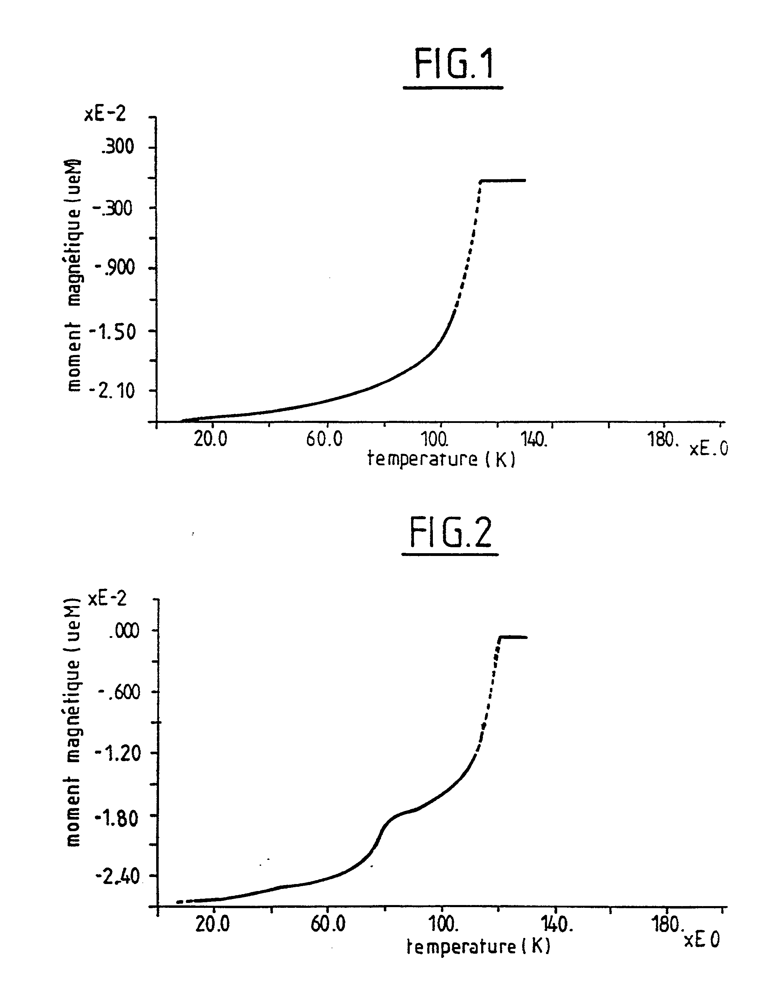

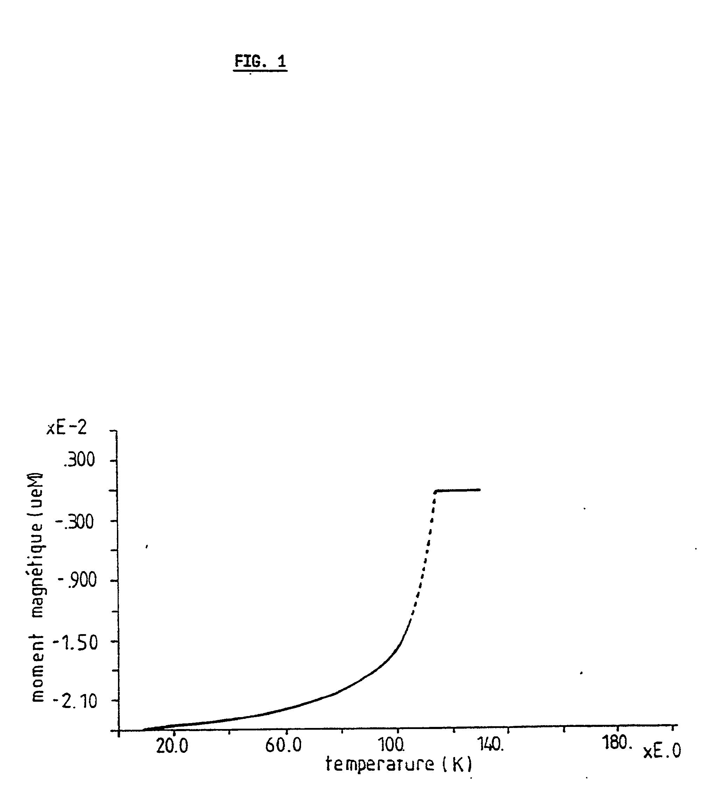

－ la figure 1 représente la courbe du moment magnétique en fonction de la température d'un produit obtenu selon le procédé de l'invention;

－ la figure 2 représente la courbe du moment magnétique en fonction de la température d'un produit obtenu selon un procédé connu.

Le procédé décrit par la Demanderesse concerne donc la préparation de phases supraconductrices à base de bismuth, strontium, calcium, cuivre et oxygène, comprenant au moins un élément stabilisant choisi parmi le plomb, l'antimoine et l'étain, et plus particulièrement les phases de formule générale suivante :

$$Bi_x M_y Sr_z Ca_t Cu_v O_w \quad (I)$$

où

$$1,5 \leqq x + y \leqq 2,5$$
$$2 \leqq v \leqq 4$$
$$3 \leqq z + t \leqq 5$$

x, y, z et t étant tous supérieurs à 0 et w étant déduit de la valeur des paramètres x, y, z, t et v et des valences des cations respectifs dans le produit;

et où M représente un ou plusieurs éléments parmi le plomb, l'antimoine ou l'étain.

A titre d'exemple, w peut varier entre 6 et 17.

Il est entendu que dans la formule donnée ci-dessus, le plomb, l'antimoine et l'étain peuvent être présents seuls ou en combinaison de deux ou trois de ces éléments dans des proportions respectives quelconques pour une valeur globale de y donnée.

Toutefois, l'invention s'applique plus particulièrement à la préparation des phases pour lesquelles M est le plomb.

L'invention s'applique aussi notamment à la préparation des produits de formule (II)

$Bi_{1,5 \pm 0,2}$ $M_{0,5 \pm 0,2}$ $Sr_{2 \pm 0,5}$ $Ca_{2 \pm 0,5}$ $Cu_{3 \pm 1}$ $O_w$
et encore plus particulièrement des produits pour lesquels M est le plomb; w étant déduit de la valeur des coefficients stoechiométiques et des valences des cations respectifs dans le produit.

Le procédé selon l'invention est du type dans lequel on utilise une solution aqueuse des sels des éléments précités. Ladite solution peut se présenter sous la forme d'une solution aqueuse de sels d'acides inorganiques ou bien encore d'une solution aqueuse de sels d'acides organiques complexants.

Ainsi, d'une part concernant les sels d'acides inorganiques, on peut utiliser tout composé donnant des sels des éléments précités solubles dans l'eau. De préférence ces sels sont des nitrates.

D'autre part, concernant les sels d'acides organiques on utilise là encore des composés dont les sels des éléments précités sont solubles dans l'eau. Selon un mode préféré de l'invention, on emploie des sels des acides $\alpha$-alcools tels que les acides citrique, malique, tartrique, glycolique, lactique.

Concernant la composition de la solution initiale, les proportions entre les divers éléments précités sont ajustées classiquement en fonction de la stoechiométrie désirée dans le produit final.

Une fois obtenue la solution aqueuse contenant les éléments constitutifs de la phase supraconductrice, on procède au séchage de ladite solution.

Le séchage peut être réalisé par tout moyen connu notamment par étuve ou par atomisation. Toutefois, on procède de préférence au séchage de la solution par atomisation.

Ainsi, tout atomiseur connu de l'homme du métier peut être utilisé pour réaliser l'atomisation et notamment les systèmes à disques ou avec buse de pulvérisation du type pomme d'arrosoir.

Le séchage de la solution peut de même être effectué en injectant celle-ci dans un gaz ayant une vitesse suffisante pour atomiser ladite solution. Dans un tel cas, la quantité de mouvement du gaz par rapport à celle de la solution doit être dans un rapport d'au moins 100, de préférence compris entre 1000 et 10000. Un tel séchage peut être effectué dans un réacteur "flash", par exemple du type mis au point par la Demanderesse et décrit notamment dans les brevets français n° 2 257 326, 2 419 754 et 2 431 321, dont l'enseignement est incorporé ici. Dans ce cas, les gaz traitants sont animés d'un mouvement hélicoïdal et s'écoulent dans un puits-tourbillon. La solution est injectée suivant une trajectoire confondue avec l'axe de symétrie des trajectoires hélicoïdales des gaz, ce qui permet de transférer parfaitement la quantité de mouvement des gaz à ladite solution. Les gaz assurent ainsi une double fonction : d'une part la pulvérisation, c'est-à-dire la transformation en fines gouttelettes, de la solution et d'autre part le séchage des gouttelettes obtenues. Par ailleurs, le temps de séjour des particules dans le réacteur est extrêmement faible, il est inférieur à 1/10 de seconde environ, ce qui supprime tout risque de surchauffe par suite d'un contact trop long avec les gaz.

Pour le séchage par atomisation, celui-ci est effectué à des températures de l'ordre de 200°C. Plus particulièrement, la température d'entrée des gaz est d'environ 250°C et la température de sortie des gaz d'environ 130°C.

Le produit issu du séchage de la solution se présente sous la forme d'une poudre. Il est ensuite calciné sous air. Cette calcination se fait habituellement à la pression atmosphérique.

La calcination est effectuée à une température comprise entre 800°C et la température de fusion du produit final, soit environ 870°C dans les conditions habituelles de pression lors de la calcination (c'est-à-dire à une pression partielle en oxygène de l'ordre de 0,22 atm).

Cependant, selon un mode préféré de l'invention, cette étape est effectuée à une température comprise entre 850 et 870°C.

La durée de calcination peut varier de 12 à 120 heures. Elle est généralement d'environ cinquante heures. Il est à noter que cette durée est considérablement moins longue que celle des calcinations des produits obtenus par les procédés antérieurs.

Le produit résultant de ladite calcination peut subir ou non une étape de broyage à sec en fonction de l'utilisation désirée du produit : poudres fines ou grossières, mise en forme du produit sous forme de pièces massives notamment.

Un exemple concret mais non limitatif va maintenant être présenté.

## EXEMPLE

Cet exemple concerne la préparation de la phase supra-conductrice $Bi_{1,6}$ $Pb_{0,4}$ $Sr_{1,6}$ $Ca_{2,4}$ $Cu_3$ $O_w$.

### 1 - Préparation des précurseurs

#### Voie A - Chamottage
On broie à sec dans un mortier les poudres $Bi_2O_3$, PbO, $SrCO_3$, $CaCO_3$ et CuO dans les proportions requises pour l'obtention de la phase précitée.

Le mélange ainsi obtenu est appelé par la suite précurseur A.

#### Voie B - voie sels selon l'invention
On prépare une solution aqueuse de nitrates de bismuth, calcium, strontium et plomb; le bismuth étant solubilisé en premier dans un excès d'acide nitrique.

Les concentrations de la solution sont telles qu'elles correspondent à [Bi] = 0,5 mol/l.

La solution aqueuse de nitrates est ensuite séchée sur un atomiseur BUCHI avec les conditions suivantes de température des gaz :
– Température entrée ≃ 240°C
– Température sortie ≃ 130°C

La poudre ainsi obtenue est appelée <u>précurseur B.</u>

## 2 - Calcination des précurseurs

Les précurseurs A et B ont été calcinés sous air à pression atmosphérique à une température de 865°C et pendant <u>48 heures.</u>

<u>Voie A</u> : Le précurseur A conduit à un mélange de phases comme le montre la courbe du moment magnétique en fonction de la température (fig. 2). En effet, il apparaît très clairement deux transitions, l'une à 115K représentant la phase <u>2223</u>, l'autre à 80K représentant la phase <u>2212</u>.

<u>Voie B</u> : Le précurseur obtenu selon l'invention conduit à une seule phase comme l'indique la courbe du moment magnétique en fonction de la température (fig. 1 ) où une seule transition apparaît à 115K, température de transition spécifique de la phase <u>2223</u>.

Ce n'est qu'après une calcination de 100 heures que le précurseur A donne une phase pure 2223.

## Revendications

1 - Procédé de préparation d'un produit supraconducteur à base de bismuth, strontium, calcium, cuivre et oxygène, comprenant au moins un élément stabilisant choisi dans le groupe comprenant le plomb, l'antimoine et l'étain caractérisé en ce qu'il comprend les étapes suivantes :

  a - préparation d'une solution comprenant les éléments bismuth, strontium, calcium, cuivre et au moins un élément stabilisant,

  b - séchage de ladite solution,

  c - calcination sous air du produit séché.

2 - Procédé selon la revendication 1, caractérisé en ce que l'on prépare un produit supraconducteur de formule :

$$Bi_x M_y Sr_z Ca_t Cu_v O_w \quad (I)$$

où

$$1,5 \leqq x + y \leqq 2,5$$
$$2 \leqq v \leqq 4$$
$$3 \leqq z + t \leqq 5$$

x, y, z et t étant tous supérieurs à 0 et

w étant déduit de la valeur des paramètres x, y, z, t et v et des valences des cations respectifs dans le produit;

et où M représente un ou plusieurs éléments parmi le plomb, l'antimoine ou l'étain.

3 - Procédé selon la revendication 2, caractérisé en ce qu'on prépare un produit de formule :

$$Bi_{1,5 \pm 0,2} M_{0,5 \pm 0,2} Sr_{2 \pm 0,5} Ca_{2 \pm 0,5} Cu_{3 \pm 1} O_w$$

M étant tel que défini précédemment et plus particulièrement le plomb; w étant déduit de la valeur des coefficients stoechiométriques et des valences des cations respectifs dans le produit.

4 - Procédé selon l'une des revendications précédentes, caractérisé en ce que la solution aqueuse des éléments précités comprend des sels d'acides inorganiques ou des sels d'acides organiques complexants.

5 - Procédé selon la revendication 4, caractérisé en ce que les sels d'acides inorganiques sont des nitrates.

6 - Procédé selon la revendication 4, caractérisé en ce que les sels d'acides organiques complexants sont des sels des acides α-alcools.

7 - Procédé selon l'une des revendications précédentes, caractérisé en ce que le séchage est effectué par atomisation.

8 - Procédé selon l'une des revendications précédentes, caractérisé en ce que le séchage est effectué par injection de la solution précitée dans un gaz ayant une vitesse suffisante pour atomiser ladite solution.

9 - Procédé selon l'une des revendications précédentes, caractérisé en ce que le séchage est effectué en injectant ladite solution, dans un réacteur suivant une trajectoire confondue avec l'axe de symétrie d'un écoulement hélicoïdal et puits-tourbillon de gaz chauds.

10 - Procédé selon la revendication 9, caractérisé en ce que le temps de séjour de la solution précitée dans le réacteur est inférieur à 1/10 de seconde environ.

11 - Procédé selon l'une des revendications précédentes, caractérisé en ce que la calcination est effectuée à une température comprise entre 800°C et la température de fusion du produit supraconducteur.

12 - Procédé selon la revendication 11, caractérisé en ce que la température de calcination est comprise entre 850°C et 870°C.

13 - Procédé selon l'une des revendications précédentes, caractérisé en ce que la durée de calcination est comprise entre 12 et 120 heures.

# FIG.1

# FIG.2

FIG. 1

EP 0 448 463 A1

Office européen
des brevets

**RAPPORT DE RECHERCHE EUROPEENNE**

Numero de la demande

EP 91 40 0746

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | JAPANESE JOURNAL OF APPLIED PHYSICS, vol. 28, no. 10, octobre 1989, pages L1797-L1799; K. MATSUMURA et al.: "Formation of Bi-Pb-Sr-Ca-Cu oxide superconducting layer from alkoxide solutions" * Pages L1797-L1798 * --- | 1,2,6, 11 | C 04 B 35/00 H 01 L 39/24 |
| Y | IDEM --- | 4,5,7, 13 | |
| Y | WPIL/DERWENT, accession no. 89-312177 [43], Derwent Publications Ltd, Londres, GB; & JP-A-1 226 724 (AGENCY OF IND. SCI. TECH.) 11-09-1989 --- | 5,7,13 | |
| Y | WPIL/DERWENT, Derwent Publications Ltd, Londres, GB; & JP-A-1 226 723 (AGENCY OF IND. SCI. TECH.) 11-09-1989 --- | 4,5,7 | |
| Y | WPIL/DERWENT, Derwent Publications Ltd, Londres, GB; & JP-A-1 230 408 (MITSUBISHI DENKI K.K.) 13-09-1989 ----- | 7 | DOMAINES TECHNIQUES RECHERCHES (Int. Cl.5) C 04 B |

Le présent rapport a été établi pour toutes les revendications

| Lieu de la recherche | Date d'achèvement de la recherche | Examinateur |
|---|---|---|
| LA HAYE | 17-06-1991 | LUETHE H. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

............................................................................
& : membre de la même famille, document correspondant

EPO FORM 1503 03.82 (P0402)

7